(19) Europäisches Patentamt
European Patent Office
Office européen des brevets

(11) EP 1 422 266 A1

(12) **EUROPEAN PATENT APPLICATION**
published in accordance with Art. 158(3) EPC

(43) Date of publication:
**26.05.2004 Bulletin 2004/22**

(21) Application number: **02730721.4**

(22) Date of filing: **27.05.2002**

(51) Int Cl.[7]: **C08L 101/00**, C08L 23/30, C08L 63/00

(86) International application number:
**PCT/JP2002/005115**

(87) International publication number:
**WO 2002/100951 (19.12.2002 Gazette 2002/51)**

(84) Designated Contracting States:
**AT BE CH CY DE DK ES FI FR GB GR IE IT LI LU MC NL PT SE TR**

(30) Priority: **31.05.2001 JP 2001164855**
**06.07.2001 JP 2001205678**

(71) Applicant: **Nippon Petrochemicals Company, Limited**
**Tokyo 100-8530 (JP)**

(72) Inventors:
- **TAKASHIMA, Tsutomu**
  **Kawasaki-shi, Kanagawa 211-0051 (JP)**
- **FUJIMURA, Kouji**
  **Kisarazu-shi, Chiba 292-0815 (JP)**

(74) Representative: **Strehl Schübel-Hopf & Partner**
**Maximilianstrasse 54**
**80538 München (DE)**

# (54) THERMOSETTING RESIN COMPOSITION

(57) The purpose of the present invention provides a thermosetting resin composition suitable for use in sealing or encapsulating semiconductor devices, which resin composition is improved in impact strength, resistance in thermal cracking test, resistance to deterioration caused by heat or by oxidation, without lowering thermal stability represented by HDT, wherein the composition containing a thermosetting resin, an epoxy group-containing liquid polybutene and, if necessary, a curing agent, and said epoxy group-containing liquid polybutene has epoxy structures substantially at the terminal ends of molecules and 80 molar % or more of repeating units in the main chain structure has a specific structure. Furthermore, the cured thermosetting resin composition has a phase structure, in which dispersed phases of several μm in diameter and being mainly composed of epoxy group-containing liquid polybutene, are dispersed in a continuous phase that is mainly composed of said thermosetting resin.

FIG. 2

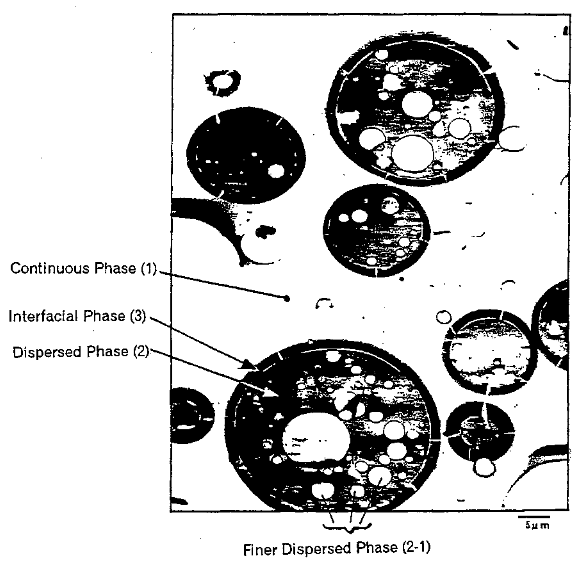




Printed by Jouve, 75001 PARIS (FR)

## Description

TECHNICAL FIELD

The present invention relates to the improvement in impact strength of thermosetting resin composition by using, for example, reactive liquid polybutene. More particularly, the invention provides an epoxy resin composition that is used for sealing or encapsulating semiconductor devices, which resin composition is improved in impact strength, resistance in thermal cracking test, resistance to deterioration caused by heat and oxidation.

BACKGROUND ART

Thermosetting resin is used singly or in combination with other resins, for various purposes. Especially, it is widely used for producing various parts of electrical appliances and machinery taking the advantages of its excellent electrically insulating property, high mechanical strength, high thermal stability, low coefficient of thermal expansion and inexpensiveness. However it has a serious disadvantage of poor toughness or tenacity that is common among other thermosetting resins. Accordingly, various attempts have been made in order to solve the problem of this kind.

In addition to the above problem, it is demanded to reduce the volume shrinkage of thermosetting resin during the curing, because it causes some troubles.

The problems due to the large volume shrinkage are exemplified by the lack of surface smoothness of SMC (Sheet Molding Compound) products, the low adhesiveness of coating film or lining finish and the deformation of FRP products caused by differences in shrinkage of various component parts.

In order to improve the impact strength of epoxy resin, one of thermosetting resins, it is well known as effective to introduce a flexible component into the epoxy resin and to use rubber particles having core-shell structure (Japanese Patent Publication No. S61-42941, Japanese Laid-Open Patent Publication No. H2-117948), to add reactive liquid rubber (Japanese Patent Publication No. S58-25391, Japanese Laid-Open Patent Publication No. H10-182937 and Japanese Patent No. 3036657) and to add reactive liquid polybutene (European Patent Publication No. 0415749). However, several problems in these methods have come into question.

For example, in a method to add a flexible component to epoxy resin, thermal stability and mechanical property such as bending strength are deteriorated. If rubber particles having a core-shell structure such as MBS powder (methyl methacrylate-styrene-butadiene copolymer particles in core-shell structure), fine particles such as composite acrylic rubber particles containing epoxy groups, or cross-linked acrylic rubber particles are blended, the viscosity is largely increased and the long-term storage stability is impaired.

In the method of blending reactive liquid rubber, such as terminal carboxyl group-modified acrylonitrile-butadiene rubber (CTBN), the above-mentioned troubles may scarcely occur. In the case of the epoxy resin composition containing CTBN, with the progress of curing, the CTBN that is dissolved in epoxy resin in the initial stage is separated out from the phase of epoxy resin to form a dispersed phase. The dispersed phase forms sea-island structure which consists of a continuous phase of cured epoxy resin composition and a dispersed phase of CTBN, and the impact strength is improved owing to this phase structure. On the other hand, when CTBN is involved within the continuous phase of epoxy resin, the thermal stability, represented by heat distortion temperature (HDT), is degraded. In other words, the sufficient control of reactivity and affinity of CTBN depending on its chemical structure cannot be attained, so that the size and distribution of dispersed CTBN phase are varied with the kind of curing agent and curing conditions, as a result, the characteristic properties of epoxy resin composition is varied. Moreover, essential problems in long-term stability such as the degradation by oxidation or by heat are well known because CTBN has unsaturated bonds in its main chains.

A liquid rubber-modified epoxy resin that is made by modifying epoxy resin with CTBN was proposed in recent years (Japanese Laid-Open Patent Publication No. 2001-089638). In this resin, however, the same problems has not been solved sufficiently.

In European Patent Publication No. 0415749 (U.S. Patent No. 5084531, U.S. Patent No. 5225486), it is proposed to epoxidize liquid polybutene having substantially no unsaturated bond in the main chains and to improve the impact strength of epoxy resin composition by using the epoxidized liquid polybutene. In this method, the epoxidized liquid polybutene having a molecular weight preferably in the range of 200 to 400 and poly-amino-amide as a curing agent are used. Thereby, suppressing the generation of phase separation structure (sea-island structure) in the obtained epoxy resin composition as being described "The mixture is then combined with the epoxy resin." and "upon examination under an electron microscope, the presence of epoxidized polybutene droplets could not be discerned in epoxy resin containing epoxidized polybutene".

In this method, it is recommended that the structure and position of unsaturated bonds of polybutene used for the epoxidizing are composed of 70 molar % of tetra-substituted structure. This means to recommend the use of polybutene raw material, which has unsaturated bonds not at molecular terminals but in main chains. Accordingly, it

is naturally supposed that epoxy groups are generated in main chains of epoxidized polybutene.

It is apparent that the reactivity of epoxy groups in main chains is inferior to the reactivity of those at terminals of molecules. Furthermore, it may easily be supposed that their reactivity lowers with the increase of molecular weight. Therefore, in this method, it is difficult to use liquid epoxidized polybutene having relatively high molecular weight, so that it is considered that the use of relatively low molecular weight liquid epoxidized polybutene is recommended.

In accordance with this proposal, the liquid epoxidized polybutene of low molecular weight is supposed to combine with the epoxy resin through epoxy groups generated in its middle part of main chain. Accordingly, the length of polybutene chain connected to epoxy resin is supposed to be extremely short. Therefore, it is difficult to form phase separation structure (sea-island structure). As described above, in view of the thermal stability represented by HDT, the method of improving impact strength by enhancing flexibility of cured epoxy resin composition in continuous phase is inferior to the improvement by means of the phase separation structure.

In this method, because liquid epoxidized polybutene containing 70 molar % of tetra-substitution structure is produced, the probability of existence of tertiary carbon atoms in main chain is high. Therefore, the degradation by oxidation or by heat is liable to occur and it is necessary to improve the long-term reliability.

On the other hand, phenol resin have been employed, alone or in combined with other resins for various uses. Especially it has been used for producing various parts of electrical appliances and machine parts with the advantages of its excellent electrically insulating property, high mechanical strength, large thermal stability, low thermal expansion coefficient, good flame retardant property and inexpensiveness. However, its inferior toughness that is a common defect among thermosetting resins is a most serious problem in the phenol resin. So that, several attempts for eliminating this problem has been made from various angles.

For example, proposed in Japanese Laid-Open Patent Publication No. S61-168652 is an improvement in impact strength of specific phenol resin by using aromatic polyester, and proposed in Japanese Laid-Open Patent Publication No. S62-209158 is an improvement in toughness of phenol resin by using specific polyethylene terephthalate, polyurethane and methyl methacrylate copolymer. However, these methods were not satisfactory because the improvement in toughness is insufficient or the fluidity of the resin is lowered.

In connection with phenol resin, the improvement by using reactive liquid rubber has also been intended widely. For example, a method of kneading emulsion polymerized latex of rubber having functional group such as epoxy group, hydroxyl group, carboxyl group or amino group with phenol resin is proposed in Japanese Laid-Open Patent Publication No. S62-59660. In a method as disclosed in Japanese Laid-Open Patent Publication No. H3-17149, an anionic surface-active agent is added to conjugated diene type rubber latex such as NBR that is highly compatible with phenol resin, the mixture is dispersed into phenol resin before the dehydration step of the resin. Furthermore, it is disclosed in Japanese Laid-Open Patent Publication No. H3-221555 that epoxidized polybutadiene and radical polymerization initiator are added to molding material in the kneading step. In these methods, although it is possible to improve the toughness of phenol resin, when rubber is added as much as to obtain sufficient toughness, the fluidity is seriously lowered, so that the practical moldability is impaired and the thermal stability of phenol resin is lost.

The present invention provides a thermosetting resin composition such as epoxy resin composition and phenol resin composition that is suitable for use in sealing or encapsulating semiconductors and so forth. The resin composition has improved properties of impact strength, thermal cracking resistance, resistance to degradation by oxidation and resistance to thermal deterioration without losing thermal stability as typically represented by HDT.

Furthermore, the thermosetting resin composition of the invention is low in the ratio of volume shrinkage, and it solved the problems in the surface smoothness of SMC (Sheet Molding Compound) products, adhesiveness or coating strength of coating film lining finish and the deformation of FRP caused by differences in volume shrinking of component parts.

## DISCLOSURE OF INVENTION

The inventors accomplished this invention by finding out that the above-mentioned problems can be resolved by using liquid polybutene containing epoxy groups of specific chemical structure.

A first aspect of the present invention relates to a thermosetting resin composition containing a thermosetting resin (A) and an epoxy group-containing liquid polybutene (B) which has epoxy groups substantially at terminal ends of molecules.

A second aspect of the present invention relates to the thermosetting resin composition according to the first aspect of the invention, wherein the epoxy group-containing liquid polybutene (B) has not less than 80 molar % of repeating unit in the main chain of the chemical structure that is represented by the formula (I).

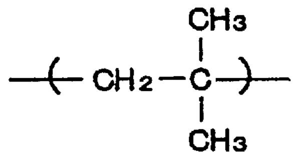 ·····(I)

A third aspect of the present invention relates to the thermosetting resin composition according to the first or the second aspect of the invention, wherein the epoxy group-containing liquid polybutene (B) has a number average molecular weight in a range of 300 to 6000.

A fourth aspect of the present invention relates to the thermosetting resin composition according to any one of the first to the third aspects of the invention, wherein the thermosetting resin composition has a phase structure of a sea-island structure mainly composed of a continuous phase (1) and dispersed phases (2).

A fifth aspect of the present invention relates to the thermosetting resin composition according to any one of the first to the third aspect of the invention, wherein the phase structure is a sea-island structure mainly composed of a continuous phase (1) and dispersed phases (2), including finer dispersed phases (2-1) within the dispersed phases (2).

A sixth aspect of the present invention relates to the thermosetting resin composition according to any one of the first to the third aspect of the invention, wherein the phase structure is a sea-island structure mainly composed of a continuous phase (1), disperse phases (2) and interfacial phases (3) which are enclosing around dispersed phases (2), respectively

A seventh aspect of the present invention relates to the thermosetting resin composition according to any one of the first to the third aspect of the invention, wherein the thermosetting resin (A) is epoxy resin or phenol resin.

An eighth aspect of the present invention relates to a method for preparing a thermosetting resin composition which is produced by curing a composition composed of a thermosetting resin (A), an epoxy group-containing liquid polybutene (B) which has epoxy groups substantially only at terminals of molecules, a curing agent (C) and a curing accelerator (D), wherein the preparation method comprises a step to produce a liquid suspension of said epoxy group-containing liquid polybutene (B) and at least one member selected from the group consisting of said thermosetting resin (A), curing agent (C) and curing accelerator (D).

In the following, the present invention is described in more detail.

The thermosetting resin (A) of the present invention means such a resin that, in the initial stage, it is usually a liquid low molecular weight compound (sometimes called as "pre-polymer"), and it is then cross-linked by chemical reaction by heating, catalyst or ultraviolet rays to form a three-dimensional network structure of high molecular weight compound. Therefore, it is not always necessarily to heat it for curing. It is typically exemplified by phenol resin, urea resin, melamine resin, epoxy resin, polyurethane, silicone resin, alkyd resin, allyl resin, unsaturated polyester resin, diallyl phthalate resin, furan resin and polyimide.

Concerning the phenol resin of thermosetting resin (A) of the present invention, there is no limitation and commercially available products can be used. It is exemplified by novolak-type phenol resin which can be obtained by heating phenol compound and formaldehyde at a molar ratio in a range of 0.5 to 1.0 in the presence of a catalyst such as oxalic acid, hydrochloric acid, sulfuric acid or toluenesulfonic acid, refluxing them to react for a suitable period of time, subjecting the reaction product to vacuum dehydration or gravity settling (decantation) for removing water, and further eliminating remained water and unreacted phenol compounds. Resol-type phenol resin can be also used by fully controlling the thermal history in the curing. These resins or co-condensation phenol resin produced by using plurality of raw materials can be used singly or in combination of two or more resins.

In connection with the epoxy resin used as the thermosetting resin (A) of the present invention, there is no limitation in property, epoxy equivalent, molecular weight and chemical structure. The compound containing two or more oxirane rings in its molecule can be used, that is, various well-known epoxy resins can be used.

The epoxy resins are exemplified by bisphenol A type resin, bisphenol F type resin, brominated bisphenol A type resin, glycidyl ether type epoxy resin such as novolak glycidyl ether type, glycidyl ester type epoxy resin such as glycidyl hexahydrophthalate and dimeric glycidyl ester, glycidyl amine type epoxy resin such as triglycidyl isocyanurate and tetraglycidyl diamino diphenylmethane, linear aliphatic epoxy resin such as epoxidized polybutadiene and epoxidized soybean oil, and alicyclic epoxy resin such as 3,4-epoxy-6-methylcyclohexyl methyl carboxylate and 3,4-epoxycyclohexyl methyl carboxylate. One or more of these resins can be used.

An epoxy resin which is in liquid at ordinary temperatures is preferably used. The glycidyl ether type epoxy resin is also exemplified, which is produced by reacting epichlorohydrin and an aromatic compound having one or more hydroxyl group under alkaline condition. More particularly, bisphenol A type epoxy resin, Epikote #828 as a commercially available product (made by Japan Epoxy Resins Co., Ltd.) is exemplified.

An epoxy group -containing liquid polybutene (B) of the present invention can be prepared by using polybutene having terminal vinylidene group through well-known reaction. The reaction is exemplified by the epoxidation of terminal vinylidene group by peroxide (U.S. Patent No. 3382255).

Japanese Laid-Open Patent Publication No. H10-306128 is named as a reference on a preparation method of polybutene containing a large quantity of terminal vinylidene structure.

In this method, polymer of olefin having four carbon atoms ($C_4$ olefin polymer) containing not less than 60 molar % of vinylidene structure can be obtained without difficulty by polymerizing isobutene singly, or isobutene with olefinic materials of butene-1 and butene-2 in the presence of boron trifluoride catalyst, because n-butene does not co-polymerize with isobutene. The molar percentage of terminal vinylidene can be identified by the integral value of peak area corresponding to olefin by $^{13}$C-NMR (Japanese Laid-Open Patent Publication No. H10-306128 in more detail).

In the present invention, the epoxy group-containing liquid polybutene (B) is used as it stands by obtaining a highly pure product or it is used as a mixture with polybutene.

For the purpose of industrial practice, it is efficient to obtain a polybutene solution containing predetermined molar % of epoxy group-containing liquid polybutene through the process, e.g., as disclosed in Japanese Laid-Open Patent Publication No. H10-306128 in which $C_4$ olefins containing isobutene, butene-1, butene-2, etc. are polymerized to obtain polybutene containing predetermined molar % or more of terminal vinylidene structure, which is followed by the reaction/conversion of a certain molar percent or more of the terminal vinylidene structure of the above $C_4$ olefin polymer. The content of functional groups of the epoxy group-containing liquid polybutene (B) can be measured by $^{13}$C-NMR method, $^{1}$H-NMR method or TLC (thin layer chromatography).

The repeating unit in the main chain of polybutene produced according to the method of the present invention has a chemical structure as shown by following formula (I):

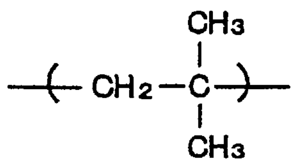 ..... ( I )

As being apparent in view of the above chemical structure, the obtained polybutene has excellent thermal stability and long term stability because it has no tertiary carbon atom that is liable to causes degradation by oxidation.

The epoxy group-containing liquid polybutene (B) of the present invention comprises a main component of epoxy group-containing liquid polybutene having terminal molecular structure of the following structural formula (II). More particularly, 50 molar % or more of the liquid polybutene is the epoxy group-containing liquid polybutene (B) having the terminal structure of the formula (II). If the content of epoxy group-containing liquid polybutene having terminal structure of the formula (II) relative to the total amount of the epoxy group-containing liquid polybutene (B) is less than 50 molar %, the problems as described in European Patent Publication No. 0415749, is caused to occur.

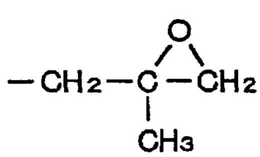 ..... ( II )

More preferable epoxy group-containing liquid polybutene (B) of the present invention has the structure as shown by the following formula (III). In the same formula, the structure that is represented by the bracket $( )_n$ is not limited to the structure itself. It is acceptable that 80 molar % or more of them correspond to the structure as shown in the bracket $( )_n$. By meeting this condition, the main chain of epoxy group-containing liquid polybutene has no tertiary carbon atom which is liable to cause degradation by oxidation. Accordingly, as described in the foregoing, it is possible to impart a quite excellent resistance to thermal deterioration to the resin composition.

The epoxy group-containing liquid polybutene having the above-mentioned chemical structure can be obtained without difficulty by the process to produce a raw material of polybutene having terminal vinylidene group and in the above-mentioned chemical structure, in accordance with Japanese Laid-Open Patent Publication No. H10-306128.

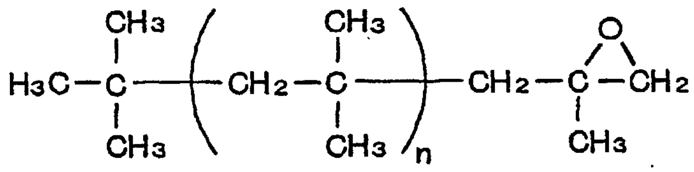

..... (III)

A more preferable epoxy group-containing liquid polybutene (B) of the present invention has a number average molecular weight in the range of 300 to 6000. It can be attained by adjusting the value of "n" in the formula (III). When the number average molecular weight is more than 6000, it may cause a problem in moldability by the increase in viscosity, although the impact strength can be improved. If the number average molecular weight is less than 300, the length of polybutene chain connected to epoxy resin becomes very short as disclosed in European Patent Publication No. 0415749 and it becomes soluble to the epoxy resin composition. Accordingly, the improvement in impact strength is mainly effected, while the lowering of thermal stability as represented by HDT is caused to occur.

For producing the thermosetting resin composition of the present invention, 1 to 200 mass parts, preferably 5 to 100 mass parts, of the epoxy group-containing liquid polybutene (B) is added to 100 mass parts in total of the thermosetting resin (A) and a curing agent (C).

As the curing agent (C) which can be used as occasion demands, any material that can react with and can cure the thermosetting resin (A) or the epoxy group-containing liquid polybutene (B) may be used. In the case of epoxy resin, the curing agents are exemplified by aliphatic polyamine, alicyclic polyamine, aromatic polyamine, acid anhydrides ( e.g., methylhexahydrophthalic anhydride, and phthalic anhydride derivative), phenolic novolak resin, polyaddition-type curing agent such as polymercaptan, aromatic tertiary amine, imidazole compound, and catalytic curing agent such as Lewis acid complex. Above curing agents can be used singly or in a mixture with other curing agent as far as the mixture does not produce any undesirable result.

In addition to the thermosetting resin (A), the curing agent (C) and the epoxy group-containing liquid polybutene (B); a curing accelerator (D) can be used in the case of epoxy resin as a thermosetting resin. It is exemplified by amine compounds such as benzyl dimethylamine (BDMA), 1-benzyl-2-phenylimidazole, 2-heptadecylimidazole, 2-phenyl-4,5-dihydroxyimidazole, 2-phenyl-4-methyl-5-hydroxymethylimidazole, 2,4-diamino-6-[2-methylimidazolyl-(1)]-ethyl-s-triazine, 1-cyanoethyl-2-undecylimidazole, 2-ethyl-4-methylimidazole, 1,8-diazabicyclo[5,4,0]undecene-7 and their salts; phosphine compounds such as triphenylphosphine and tris(2,6-dimethoxyphenyl)-phosphine and their salts; and organometallic salt such as tin octylate.

In the case of preparation of the thermosetting resin composition of the present invention using, for example, epoxy resin as a thermosetting resin, 0 to 20 mass parts of curing accelerator (D) can be added to 100 mass parts in total of thermosetting resin (A) and curing agent (C).

In order to carry out more effectively to suppress the lowering of thermal stability represented by HDT and to improve impact strength and thermal cracking resistance of the effects of the present invention, it is desirable that the main structure is a sea-island structure of cured thermosetting resin composition consisting of continuous phase (1) and dispersed phases (2) (hereinafter referred to as "Phase Structure I"). This structure can be observed by an electron microscope. The continuous phase is mainly composed of a cured composition containing thermosetting resin (A) (hereinafter referred to as "cured material") and the dispersed phase is mainly composed of the epoxy group-containing liquid polybutene (B).

More preferably, the main phase structure of thermosetting resin composition that is observed by an electron microscope is a sea-island structure consisting of a continuous phase (1) and dispersed phases (2), including finer dispersed phases (2-1) inside' the dispersed phases (2) (hereinafter referred to as "Phase Structure II"), or a sea-island structure mainly consisting of a continuous phase (1), dispersed phases (2) and interfacial phases (3) which surround around the respective dispersed phases (2) (hereinafter referred to as "Phase Structure III").

The most preferable phase structure of the present invention is the one which has both the "Phase Structure II" and "Phase Structure III", simultaneously. Any of "Phase Structure I", "Phase Structure II" and "Phase Structure III" is not disclosed in the foregoing European Patent Publication No. 0415749.

In the following, the effect of "Phase Structure I", "Phase Structure II" and "Phase Structure III" to improve impact strength according to the present invention will be described.

Phase Structure I has dispersed phases (2) each having a diameter of several μm, which is mainly composed of the epoxy group-containing liquid polybutene and elastic and tough material having a low elastic modulus, and dispersed in the continuous phase (1) that is mainly composed of cured material and is brittle with a high elastic modulus. When Phase Structure I is deformed by stress, the force of exfoliation is caused to occur by the difference in Poisson's ratios between both constituent materials of continuous phase (1) and dispersed phases (2) and the interfacial exfoliation of both phases is propagated. In Phase Structure I, large energy is consumed to propagate the interfacial exfoliation between continuous phase (1) and dispersed phases (2) because the affinity between both the continuous phase (1) and dispersed phases (2) is increased by the similarity of chemical structures of these phases. It is considered that large energy is consumed by the exfoliation because affinity between chemical structure of continuous phase (1) and dispersed phase (2) is increased. Because the stress (distortion) is consumed (released) by the interfacial exfoliation, cracks as the fatal breakage is not caused to occur in the continuous phase that is mainly composed of the thermosetting resin of cured epoxy resin. As a result, the impact strength and thermal cracking resistance can be improved.

Phase Structure II is composed of continuous phase (1) which is mainly composed of a brittle cured material with a high elastic modulus, dispersed phases (2) each having a diameter of several μm and mainly composed of elastic but tough material with a low elastic modulus of the epoxy group-containing liquid polybutene (B) and being inside the continuous phase (1), and finer dispersed phases (2-1) that are dispersed in and are finer than the dispersed phases (2). The finer dispersed phases are mainly composed of a cured resin. This phase structure is observed in high impact strength polystyrene and ABS resin and called salami structure. When deformation is caused to occur in Phase Structure II by stress, also in the dispersed phases (2), the stress (distortion) is consumed (released) by the exfoliation in the interfaces of the finer dispersed phases (2-1), in addition to the occurrence in Phase Structure I. Accordingly, interfacial exfoliation energy per unit volume is larger than that in Phase Structure I. Therefore, cracks as the fatal breakage is not caused to occur in the continuous phase (1) that is mainly composed of the thermosetting resin of cured epoxy resin, so that the impact strength and thermal cracking resistance can effectively be improved.

Phase Structure III is composed of interfacial phases (3) each having a size in the range of several μm and surrounding the respective dispersed phases (2), in addition to the dispersed phases (2) of the size in the range of several μm that are dispersed in the continuous phase (1). The continuous phase (1) is mainly composed of cured material which is brittle with a high elastic modulus and the dispersed phases (2) are mainly composed of the epoxy group-containing liquid polybutene (B) which is elastic but tough with a low elastic modulus. The interfacial phases (3) are mainly composed of a component produced by the reaction between the cured material of the thermosetting resin (A) and the epoxy group-containing liquid polybutene (B) that is brittle material with a high elastic modulus. This phase structure can be confirmed by the structure of high impact strength polypropylene, the so-called multilayer structure. In the high impact strength polypropylene, it is observed that dispersed phase of polyethylene exists in continuous phase of polypropylene with interfacial phases of ethylene-propylene copolymer rubber surrounding the dispersed phase. When the Phase Structure III is deformed by stress, the stress (distortion) is also consumed (released) by exfoliation at the interfaces of interfacial phases (3) from the continuous phase (1) and from the dispersed phases (2), in addition to the effect in Phase Structure I. Accordingly, the interface exfoliation energy per unit volume is larger than that of Phase Structure I. Therefore, cracks which bring about fatal breakage of cured continuous phase (1) are not caused to occur. As a result, it improves the impact strength and thermal cracking resistance more effectively.

In the case of phase structure which can meet both the Phase Structure II and Phase Structure III, finer dispersed phase (2-1) of a diameter in the range of several μm exists inside the dispersed phase (2) and the interfacial layer (3) of a thickness in the range of μm is surrounding around the dispersed phase (2), besides the dispersed phase (2) exists in continuous phase(1). In this phase, the continuous phase (1) is mainly comprised of the cured resin which is brittle material with high elastic modulus and the dispersed phase (2) is mainly comprised of the epoxy-containing liquid polybutene (B) and elastic or tough material with low elastic modulus. And the finer dispersed phase (2-1) is mainly comprised of cured material. The interface layer (3) is mainly composed of the reaction product of cured material of composition containing the thermosetting resin(A) and epoxy-containing liquid polybutene(B), which is elastic and tough material with low elastic modulus. In this phase, the energy per unit volume consumed by interfacial separation is larger than that of Phase Structure II or Phase Structure III. Therefore, it does not produce any crack which causes fatal breakage of material inside the continuous phase which is mainly compose of cured material. As a result, it can improve the impact strength and resistance to thermal cracking quite effectively

Decrease in volume shrinkage ratio of the thermosetting resin of the present invention is basically dependent on the low volume shrinkage ratio of epoxy-group containing liquid polybutene and chemical interaction relative to the thermosetting resin. It is also supposed that the foregoing structure of Phase Structure I, Phase Structure II and Phase Structure III contributes not only in the stress releasing when impact is applied but also the stress releasing the curing process.

In order to form the above-mentioned Phase Structure I, Phase Structure II and Phase Structure III as a main phase structure of the thermosetting resin composition, it is desirable to employ a step to prepare a suspension by mixing a part of component selected from a thermosetting resin (A), a curing agent (C) and a curing accelerator (D) with the epoxy group-containing liquid polybutene (B), hereinafter referred to as "liquid suspension mixture", before obtaining the final cured composition that is composed of (A), (B), (C) and (D).

In this step, one member of selected from the thermosetting resin (A), curing agent (C) and curing accelerator (D) is mixed with the epoxy group-containing liquid polybutene (B) to form a minute dispersed phase (liquid suspension mixture) mainly composed of the epoxy group-containing liquid polybutene (B) in the liquid mixture.

This suspended state means that, after the mixing, the suspension does not substantially change its suspended state under the conditions of mixing process for one day or longer, more preferably the suspension is not changed for one month or more.

It can be confirmed by electron microscopic observation concerning the phase structure that the main portion consists of a plurality of finer dispersed phases (2-1) exists in the dispersed phase (2) and/or at least one layer of interfacial phase (3) surrounds all around the dispersed phase (2).

This procedure provides, before the curing, the condition contributing to form the phase structure that is preferable for the improvement of impact strength of final obtainable thermosetting resin composition.

Although the reason that the stable suspended state can be formed is not clearly known, it is considered that the chemical reaction product of dissolved epoxy group-containing liquid polybutene (B) with thermosetting resin (A), and/or the product of dissolved epoxy group-containing liquid polybutene (B) with curing agent (C) exert the function like a surface-active agent in the mixture.

The liquid suspension mixture can easily be obtained by maintaining the compounding ratios of the respective components such that the relation of functional group equivalent (g/eq.) of each component is set into the following specific range. The functional group equivalent (g/eq.) herein referred to means the epoxy equivalent (g/eq.) in the case of the thermosetting resin is an epoxy resin, while the active hydrogen equivalent (g/eq.) in the case of a phenol resin. Similarly, it means acid anhydride group equivalent in the case of an acid anhydride curing agent and amino group equivalent in the case of an amine curing agent. Furthermore, it is possible to indicate it with the total amount of reactive functional group equivalent (g/eq.) when several functional groups exist.

The ratio of functional group equivalents (g/eq.) of the thermosetting resin (A) to the curing agent (C), as represented by (A)/(C), is 5 or more, preferably 10 or more but not more than 20. Otherwise, the ratio of (A)/(C) may be not more than 0.2, preferably not more than 0.1 but not less than 0.001. As described above, the liquid suspension mixture of the present invention can be obtained by preparing a mixture containing component (A) and (C) with excess amount of either one of the two components, that is, the liquid suspension mixture of the invention can be prepared by mixing 1 to 100 parts by mass of epoxy group-containing liquid polybutene (B) into 100 parts by mass of the mixture. The ratio of (A)/(B) of an ordinary thermosetting resin composition is generally in the range of 0.5 to 1.5, however, the composition of the invention can be prepared by using a large excess amount of either one of components in the step of preparing the liquid suspension mixture.

When the ratio of (A)/(B) is less than 5 but more than 0.2, the viscosity of liquid suspension mixture increases markedly which is not suitable for practical uses, although it is possible to form the above-mentioned structure in a final product of thermosetting resin composition. If 100 parts by mass or more of epoxy group-containing liquid polybutene (B) is used relative to 100 parts by mass of the liquid suspension mixture, the viscosity of the liquid suspension mixture increases markedly like the above-mentioned case.

If the curing agent (C) is not used, 1 to 200 parts by mass of the epoxy group-containing liquid polybutene (B) must be used to 100 parts by mass of the thermosetting resin (A).

When the epoxy group-containing liquid polybutene (B) of not less than 200 parts by mass is used relative to 100 parts by mass of the thermosetting resin (A), the viscosity of liquid suspension mixture itself increases markedly, which is not suitable for practical uses in the like manner as the above.

The temperatures, time lengths and methods of adding respective components for preparing the liquid suspension mixture are not especially limited. There is no limitation in the method of stirring the components as far as uniform mixing can be attained. In the case that a specific size of dispersed particles is required, it is desirable to control by using a forced stirrer such as homogenizer.

The liquid suspension mixture as described above can contribute to the formation of a preferable phase structure with high impact strength in a succeeding step of producing final thermosetting resin composition. In this final step, the thermosetting resin (A) and/or the curing agent (C), and if necessary, a curing accelerator (D) are supplemented to the liquid suspension mixture obtained before the step in order to adjust final ratio of functional group equivalent of (A) to (C) in the range of 0.2 to 5, preferably 0.5 to 1.5.

The thermosetting resin composition of the present invention can be obtained by hardening the composition by a suitable means such as heating, adding catalyst or irradiation with ultraviolet rays after the ratios of component materials were adjusted into appropriate ranges.

In the use of the obtained composition for various practical purposes, in addition to the above-mentioned components, well-known liquid reactive rubber, liquid rubber such as liquid a -olefin polymer, elastomer, impact modifier such as core-shell structure elastomer, flame 'retardant, coupling agent, defoaming agent, pigment, dye stuff, antioxidant, weatherproof agent, lubricant, filler such as releasing agent can be blended appropriately as far as the effect of the present invention is not obstructed.

Concerning the filler, it is exemplified by fused silica, crushed silica, talc, calcium carbonate, aluminum hydroxide and so forth. Among them, fused silica having an average particle size of less than 20 μm is desirable in the use for sealing or encapsulating semi-conductors that is demanded in recent years. These additives can be used singly

or in combined with two kinds or more appropriately

BRIEF DESCRIPTION OF DRAWINGS

Figure 1 shows an enlarged view of liquid suspension mixture obtained in Example 5 of the present invention. Figure 2 shows an enlarged view of the phase structure of thermosetting resin composition as obtained in Example 17. Figure 3 shows an enlarged view of the phase structure of cured resin sample as obtained in Comparative Example 3 of the present invention.

BEST MODE FOR CARRYING OUT THE INVENTION

The present invention is described in more detail by referring to specific examples.

[Reference Preparation Examples]

<Preparation of epoxy group-containing liquid polybutene (epoxidized polybutene)>

Used in Reference Preparation Examples 1 and 2 were commercially available LV-50 (trade name; produced by Nippon Petroleum Chemicals Co., Ltd.) and HV-100 (trade name; produced by Nippon Petroleum Chemicals Co., Ltd.) as reactant materials of polybutene for preparing epoxidized polybutene as being indicated in Table 1. In Reference Preparation Examples 3 to 6, highly reactive polybutene was used, that was obtained in accordance with the method disclosed in Japanese Laid-Open Patent Publication No. H10-306128, which was proposed by the present inventors. The highly reactive polybutene was also used in Comparative Example 1 and HV-300 (trade name; produced by Nippon Petroleum Chemicals Co., Ltd.) was used in Comparative Example 2.

Epoxidized polybutenes (in Reference Preparation Examples 1 to 6) were prepared by the reaction of peracid with raw materials of the foregoing 6 kinds of polybutenes with reference to the method as described in U.S. Patent No. 3,382,255.

Table 1

| Reference Preparation Example | Raw Material for Epoxidized Polybutene | Mn (*1) |
|---|---|---|
| 1 | LV-50 | 430 |
| 2 | HV-100 | 980 |
| 3 | Highly reactive Polybutene | 370 |
| 4 | Highly reactive Polybutene | 650 |
| 5 | Highly reactive Polybutene | 1300 |
| 6 | Highly reactive Polybutene | 2300 |

*1: Number average molecular weight is measured by GPC (in terms of Polystyrene)

[Examples 1 to 12]

<Preparation of liquid suspension mixture before final curing reaction>

A flask having a variable speed stirrer, a reaction temperature indicator and a reactant dropping port, was placed in a thermostat bath.

Prescribed amounts of epoxidized polybutenes produced in Reference Preparation Examples 1 to 6 (shown in Table 2) were taken and prescribed amounts (also shown in Table 2) of thermosetting resin of Epikote #828, curing agent of MH-700 and curing accelerator of BDMA were fed together into the respective flasks. The mixtures were heated from the room temperature up to 100°C with stirring and the reaction were continued for subsequent two hours at 100°C

As a result, under any conditions of Examples 1 to 12, liquid suspension mixtures could be obtained. Although they were left to stand still for one month, none of phase separation was observed. The liquid suspension mixture obtained in Example 5 was observed by an optical microscope, with which it was confirmed that the phase structure

consists of particles of dispersed phase (2) that are dispersed in the continuous phase (1) as shown in Figure 1.

<Description of the commercial products used in Examples>

1) Epikote #828 (produced by Japan Epoxy Resins Co., Ltd.)

An epoxy resin mainly comprising bisphenol A type diglycidyl ether. Functional group (epoxy group) equivalent is about 190 g/eq.

2) MH-700 (produced by Shin Nihon Rika Co., Ltd.)

An acid anhydride type curing agent mainly comprising methylhexahydrophthalic anhydride. Functional group (acid anhydride group) equivalent is about 168 g/eq.

3) BDMA (reagent grade product of Tokyo Kasei Industry Co., Ltd.)

A curing accelerator mainly comprising benzyl dimethylamine.

Table 2

| Example | Reactive Monoolefine Polymer | Thermo-setting Resin | Curing Agent | Curing Accelerator |
|---|---|---|---|---|
| | Epoxidized Polybutene | Epikote #828 | MH-700 | BDMA |
| 1 | Reference Preparation Example 1: 9.5 g | 130.0 g (684 meq) | 4.5 g (27 meq) | 0.90 g |
| 2 | Reference Preparation Example 2: 21.6 g | 130.0 g (684 meq) | 4.5 g (27 meq) | 0.90 g |
| 3 | Reference Preparation Example 3: 8.1 g | 130.0 g (684 meq) | 4.5 g (27 meq) | 0.90 g |
| 4 | Reference Preparation Example 4: 14.3 g | 130.0 g (684 meq) | 4.5 g (27 meq) | 0.90 g |
| 5 | Reference Preparation Example 5: 28.6 g | 130.0 g (684 meq) | 4.5 g (27 meq) | 0.90 g |
| 6 | Reference Preparation Example 6: 50.6 g | 130.0 g (684 meq) | 4.5 g (27 meq) | 0.90 g |
| 7 | Reference Preparation Example 1: 9.5 g | 4.0 g (21 meq) | 65.9 g (392 meq) | 0.90 g |
| 8 | Reference Preparation Example 2: 21.6 g | 4.0 g (21 meq) | 65.9 g (392 meq) | 0.90 g |
| 9 | Reference Preparation Example 3: 8.1 g | 4.0 g (21 meq) | 65.9 g (392 meq) | 0.90 g |
| 10 | Reference Preparation Example 4: 14.3 g | 4.0 g (21 meq) | 65.9 g (392 meq) | 0.90 g |
| 11 | Reference Preparation Example 5: 28.6 g | 4.0 g (21 meq) | 65.9 g (392 meq) | 0.90 g |
| 12 | Reference Preparation Example 6: 50.6 g | 4.0 g (21 meq) | 65.9 g (392 meq) | 0.90 g |

[Comparative Examples 1 to 2, Comparative Examples 7 to 8]

In each Comparative Example, the same devices as those in the foregoing examples were used under the conditions as indicated in Table 3. Reaction temperature and retention time were same as those in the foregoing examples. In these cases, liquid suspension mixtures can also be obtained in the like manner as the foregoing examples

and any phase separation after one month was not observed, either. However, in mixtures of Comparative Examples 7 and 8, viscosities became extremely high without fluidity, so that they were not used practically.

Table 3

| Comparative Example | | Thermo-setting Resin | Curing Agent | Curing Accelerator |
|---|---|---|---|---|
| | Additional Component | Epikote #828 | MH-700 | BDMA |
| 1 | Highly Reactive Polybutene (Mn 1300): 28.6g | 130.0 g (684 meq) | 4.5 g (27 meq) | 0.90 g |
| 2 | HV-300 (Mn1300): 28.6g | 130.0 g (684 meq) | 4.5 g (27 meq) | 0.90 g |
| 7 | Reference Preparation Example 1: 9.5g | 130.0 g (684 meq) | 38.0 g (228 meq) | 0.90 g |
| 8 | Reference Preparation Example 5: 28.6g | 29.9 g (157 meq) | 65.9 g (392 meq) | 0.90 g |

[Examples 13 to 21, Comparative Examples 3 to 6]

<Examples of curing of epoxy resin and evaluation of final resin composition>

In the examples, thermosetting resin compositions were represented by epoxy resin composition. The epoxy resin compositions of the present invention were prepared through the following procedure. In Examples 1 to 6 and Comparative Examples 1 to 2, MH-700 was added to the liquid suspension mixture to supplement the shortage for the final amount of composition adjusting the equivalent ratio of functional group of curing agent/epoxy resin as shown in Table 4. Then these were stirred at room temperature to be uniformly mixed. Furthermore, 1 phr of BDMA was added to each mixture and then each epoxy resin composition was obtained after subjecting them through three step thermal histories of (1) 100°C for two hours, (2) 120°C for two hours and (3) 140°C for two hours.

In Comparative Example 5, the same weight of the existing material of modified acrylonitrile-butadiene rubber CTBN 1300X8 (produced by Ube Industries, Ltd.) was added, without the purpose to produce liquid suspension mixture of the present invention. In Comparative Example 6, stress releasing material of flexible component was not added at all. In both Comparative Examples, equivalent ratio of epoxy resin and curing agent, amount of curing accelerator and thermal history were the same as those in Examples 13 to 21 and Comparative Examples 3 and 4.

Epoxy resin composition was evaluated by five items of flexibility, resistance to humidity, resistance to cracking, chemical resistance and thermal resistance. Each composition of these examples and comparative examples was molded into suitable specimen for each evaluation test.

<Evaluation Method >

Each evaluating method is described in the following.

1) Flexibility

Flexibility of cured composition was evaluated by three items of (1) Barcol hardness, (2) flexural yield strength and (3) flexural modulus test in accordance with JIS K 6911. In Barcol hardness test and flexural yield strength test, the values were represented by the average of five times' tests. In flexural modulus test, the average of ten times' tests was obtained.

2) Resistance to Humidity

Resistance to humidity was evaluated by the change of weight of cured specimen before and after soaking in boiling water for 10 hours. The test was done twice and the average of results of them were obtained.

3) Resistance to Cracking

Resistance to cracking was measured using cured specimen in which metallic washers of different thermal conductivity were buried according to JIS C 2105 (Testing method of solventless liquid resin for electrical insulation). The result was calculated by the observation of average numbers of cracks of five specimens that were cooled from 150°C to 0°C.

4) Chemical Resistance

Cured specimen was soaked in an aqueous solution of 10% sodium hydroxide or n-heptane for three days. The changes in weights of specimens during the soaking were determined. The result was obtained by the average of two times' tests.

5) Thermal Stability

Heat distortion temperature (HDT) was measured in accordance with JIS K 6911. The thermal stability of cured composition was evaluated in terms of HDT, which was represented by the average of five times' measurement.

6) Shrinkage Ratio

Volume shrinkage percentage was calculated by the following formula in accordance with JIS K 6911.

$$\text{Volume shrinkage percentage} = (\text{density after curing - density before curing})/(\text{density after curing}) \times 100$$

Density before curing was obtained by extrapolation at zero hour on the values of density of each mixed composition measured at regular intervals from the beginning of mixing. In the case that reaction occurs during the raising of temperature, the density of mixture was calculated from the densities of respective components.
Density after curing was obtained by measuring the mass in silicone oil or in distilled water.

7) Ratio of Water Absorption

The ratio of water absorption was measured according to JIS K7114.
In Tables 4 and 5, the mixing conditions and evaluated physical data of epoxy resin compositions are shown.

Table 4

| Mixing Condition | | Example | | | | | | Comparative Example | | | |
|---|---|---|---|---|---|---|---|---|---|---|---|
| | | 13 | 14 | 15 | 16 | 17 | 18 | 3 | 4 | 5 | 6 |
| Curing Agent / Epoxy Resin | MH700/ Epikote #828 (Ratio of Functional Group Equivalents) | 0.9 | 0.9 | 0.9 | 0.9 | 0.9 | 0.9 | 0.9 | 0.9 | 0.9 | 0.9 |
| Flexible Component (*1) | Component of Example 1 | 17 | | | | | | | | | |
| | Component of Example 2 | | 17 | | | | | | | | |
| | Component of Example 3 | | | 17 | | | | | | | |
| | Component of Example 4 | | | | 17 | | | | | | |
| | Component of Example 5 | | | | | 17 | | | | | |
| | Component of Example 6 | | | | | | 17 | | | | |
| | Component of Comparative Example 1 | | | | | | | 17 | | | |
| | Component of Comparative Example 2 | | | | | | | | 17 | | |
| | CTBN 1300×8 | | | | | | | | | 17 | |
| | No Addition | | | | | | | | | | 0 |
| Curing (*1) Accelerator | BDMA | 1 | 1 | 1 | 1 | 1 | 1 | 1 | 1 | 1 | 1 |
| Evaluation | | | | | | | | | | | |
| Flexibility | (1) Barcol Hardness | 0 | 0 | 0 | 0 | 0 | 0 | 0 | 0 | 13 | 37 |
| | (2) Flexural Yield Strength($kg/mm^2$) | 6.4 | 5.3 | 3.7 | 5.9 | 5.1 | 3.6 | 4.7 | 4.5 | 6.8 | 12.7 |
| | (3) Flexural Modulus($kg/mm^2$) | 212 | 189 | 237 | 214 | 177 | 159 | 147 | 142 | 187 | 307 |
| Resistance to Humidity | Resistance to Boiling Water | 1.1 | 1.0 | 1.3 | 1.0 | 1.0 | 1.0 | 1.0 | 1.0 | 1.1 | 1.0 |
| Resistance to Cracking | Average Number of Cracks | 1 | 1 | 0 | 0 | 0 | 0 | 3 | 4 | 0 | 7 |
| Chemical Resistance | Resistance to 10% NaOH Soln. | 0.2 | 0.2 | 0.2 | 0.2 | 0.2 | 0.3 | 0.2 | 0.2 | 0.3 | 0.2 |
| | Resistance to n-Heptane | 0.0 | -0.1 | -0.1 | -0.1 | -0.2 | -0.3 | -0.2 | -0.2 | 0.1 | -0.1 |

*1: Numerals in Table indicate percentages of the reactive mono-olefin polymer or added component in the cured composition.

Table 4 (continued)

| Mixing Condition | | Example | | | | | | Comparative Example | | | |
|---|---|---|---|---|---|---|---|---|---|---|---|
| | | 13 | 14 | 15 | 16 | 17 | 18 | 3 | 4 | 5 | 6 |
| Curing Agent / Epoxy Resin | MH700/ Epikote #828 (Ratio of Functional Group Equivalents) | 0.9 | 0.9 | 0.9 | 0.9 | 0.9 | 0.9 | 0.9 | 0.9 | 0.9 | 0.9 |
| Thermal Analysis | HDT(°C) | 118 | 128 | 110 | 125 | 129 | 130 | 128 | 127 | 102 | 133 |

Table 5

| Mixing Condition | | Example | | | | Comparative Ex. |
|---|---|---|---|---|---|---|
| | | 17 | 19 | 20 | 21 | 6 |
| Curing Agent / Epoxy Resin | MH700/ Epikote #828 (Ratio of Functional Group Equivalent) | 0.9 | 0.9 | 0.9 | 0.9 | 0.9 |
| Flexible Component (*1) | Component of Example 5 Example 5 | 17 | 5 | 10 | 24 | 0 |
| Curing (*1) Accelerator | BDMA | 1 | 1 | 1 | 1 | 1 |
| Evaluation | | | | | | |
| Flexibility | (2) Flexural Yield Strength ($kg/mm^2$) | 5.1 | 7.4 | 5.9 | 4.0 | 12.7 |
| | (3) Flexural Modulus ($kg/mm^2$) | 177 | 258 | 224 | 147 | 307 |
| Resistance to Humidity | Resistance to Boiling Water | 1.0 | 1.0 | 0.9 | 1.0 | 1.0 |
| Chemical Resistance | Resistance to 10% Resistance to 10% NaOH Solution | 0.2 | 0.2 | 0.2 | 0.2 | 0.2 |
| | Resistance to n-Heptane | -0.2 | -0.1 | -0.1 | -0.5 | -0.1 |
| Thermal Analysis | HDT (°C) | 129 | 136 | 134 | 130 | 133 |
| Curing Characteristics | Shrinkage Ratio (%) | 0.3 | — | 0.8 | 0.0 | 2.0 |
| | Ratio of Water Absorption | 0.1 | — | 0.1 | 0.1 | 0.1 |

*1: Numerals in Table indicate percentages of the reactive mono-olefin. polymer or added component in the cured composition.

<Observation of Phase Structure>

The phase structures of examples and comparative examples were observed by transmission electron microscope (TEND (tradename: JEM-1010, made by JEOL Ltd.). Specimens were stained with ruthenium oxide and they were observed at 100 kV of applied voltage. As a result, it was judged that the stained phase mainly comprises polybutene material. In the observation of Examples 15 to 18, it was confirmed to have Phase structure II or Phase structure III of the present invention. Figure 2 shows observed result of Example 17. In Comparative Examples 3 to 6 and Examples 13 to 14, it was confirmed to have Phase Structure I of the present invention. It also shows in Figure 3 the observed result of Comparative Example 3.

[Comparative Example 9]

It was tried to obtain the same impact resistant thermosetting resin composition as in Example 13 containing the same compounding ratios of constituent materials as the final product by feeding all components at one time without the step of forming liquid suspension mixture described in Example 1. The reaction time and temperature were made the same as those in Example 1. However, it was confirmed that the thermosetting resin having the effect of the present invention could not obtained by this method because phase separation of cured resin composition containing thermosetting resin from the reactive mono-olefin polymer was observed.

[Examples 100 to 102]

<Preparation of suspended mixture before final curing>

The same reaction apparatus as those in Examples 1 to 12 were employed. As shown in Table 6, predetermined amount of YDCN-702 (produced by Toto Kasei Co., Ltd.) as thermosetting resin, MH-700 (produced by Shin Nihon Rika Co., Ltd.) as curing agent and BDMA as curing accelerator were supplied simultaneously to predetermined amount of epoxidized polybutene of Reference Preparation Example 5 in a flask. The temperature of the mixtures was then raised to 120°C from room temperature with mixing and reaction was carried out for 30 minutes at 120°C. Consequently, in any conditions of Examples 100 to 102, liquid mixtures with suspended state were obtained at the time of reaction. The mixtures turned to solid powder at room temperature. The mixtures did not cause phase separation after one month.

<Description on commercial products used for examples>

1) YDCN-702 (produced by Toto Kasei Co., Ltd.)

YDCN-702 is epoxy resin which is mainly comprised of o-cresol type. The functional group (epoxy group) equivalent is about 205 g/eq.

2) MH-700 (produced by Shin Nihon Rika Co., Ltd.)

MH-700 is an acid-anhydride type curing agent, which is mainly composed of methylhexahydrophthalic anhydride. The functional group (acid anhydride ) equivalent is about 168 g/eq.

3) BDMA (reagent; produced by Tokyo Kasei Industry Co., Ltd.)

BDMA is a curing accelerator which is mainly composed of benzyl dimethylamine.

Table 6

| Example | Reactive Mono-olefin Polymer | Thermosetting Resin | Curing Agent | Curing Accelerator |
|---|---|---|---|---|
| | Epoxidized polybutene | YDCN-702 | MH-700 | BDMA |
| 100 | Preparation Example for reference 5: 10.6g | 100.0 g (488 meq) | 3.8 g (23 meq) | 0.10 g |
| 101 | Preparation Example for reference 5: 21.2g | 100.0 g (488 meq) | 3.8 g (23 meq) | 0.10 g |
| 102 | Preparation Example for reference 5: 29.4g | 100.0 g (488 meq) | 3.8 g (23 meq) | 0.10 g |

[Examples 200 to 202, Comparative Examples 100]

<Preparation of cured phenol resin compositions and their evaluation>

Phenol resin compositions of the present invention were produced in the following procedure.

Predetermined amount of novolak-phenol curing agent TD-2131 (produced by DIC Co., Ltd.) was added to each suspended mixture produced in Examples 100 to 102 with adjusting the final amount ratio of composition as shown in Table 7. Then, 1 phr of TPP (triphenyl phosphine) was added to the mixture respectively as a curing accelerator. Thereafter the mixture was stirred to be uniform by using Plastmill (manufactured by Toyo Seiki Co., Ltd.) at 120°C and each phenol resin composition was obtained.

In Comparative Example 100, no stress releasing material was added. In this case, chemical equivalent ratio of o-cresol type epoxy resin to novolak-phenol curing agent, amount of curing accelerator and stirring method under heating were same as those in the foregoing conditions.

Phenol resin compositions were evaluated with two items of flexibility and thermal stability. Each composition

of these Examples and Comparative Example 100 was molded by hot press into suitable specimens for each evaluation test.

<Evaluating Method >

Each evaluating method is described in the following.

1) Flexibility

Flexibility was evaluated by two items of (1) flexural yield strength test and (2) flexural modulus test in accordance with JIS K 6911. In both tests, the averages of five times' test were obtained.

2) Thermal Stability

Heat distortion temperature (HDT) was measured in accordance with JIS K6911. Thermal stability of cured composition was evaluated by HDT. The result was obtained by the average of five times' test.

Mixing condition and evaluated result of each phenol resin composition were shown in Table 7.

Table 7

| Mixing condition | | Example | | | Comparative Ex. |
|---|---|---|---|---|---|
| | | 200 | 201 | 202 | 100 |
| Curing Agent / Epoxy Resin | TD2131/ YDCN-702 (Equivalent Ratio of Functional Group) | 1.0 | 1.0 | 1.0 | 1.0 |
| Flexible Component (*1) | Component of Example 100 | 6 | | | |
| | Component of Example 101 | | 12 | | |
| | Component of Example 102 | | | 18 | |
| | Not Added | | | | 0 |
| Curing(*1) Accelerator | T P P | 1 | 1 | 1 | 1 |
| Evaluation | | | | | |
| Flexibility | (2) Flexural Yield Strength(kg/mm$^2$) | 6.4 | 5.9 | 4.5 | 7.7 |
| | (3) Flexural Modulus(kg/mm$^2$) | 274 | 259 | 237 | 295 |
| Thermal Analysis | HDT (°C) | 152 | 150 | 149 | 152 |

*1: Numerals in Table indicate percentages of epoxidized polybutene to total amount of composition.

<Observation of phase structure>

In the like manner as the foregoing cured epoxy resin compositions, each phase structure of above-mentioned cured example was observed by TEM. It was confirmed that Phase Structure II of the present invention was formed in all examples.

INDUSTRIAL APPLICABILITY

It became to confirm to resolve the outstanding problem about physical properties of thermosetting resin composition by curing the present invention which is comprised of thermosetting resin, curing agent, curing accelerator

and epoxy group-containing liquid polybutene which has specific chemical structure. It is due to main phase structure of sea-island structure mainly composed of a continuous phase of mainly cured component containing of thermosetting resin and dispersed phase of mainly epoxy group-containing liquid polybutene. Furthermore it is also due to phase structure having plural finer dispersed phases than the dispersed phase within the dispersed phase and/or at least one interfacial phase enclosing around the dispersed phase, respectively.

And it also became to know that it is possible to generate above-mentioned phase structure by preparing a liquid suspension of epoxy group-containing liquid polybutene and at least one member selected from the group consisting of thermosetting resin, curing agent and, if necessary, curing accelerator, in advance of producing final thermosetting resin composition.

## Claims

1. A thermosetting resin composition containing a thermosetting resin (A) and epoxy group-containing liquid polybutene (B), in which polybutene epoxy structures are formed substantially at terminal ends of molecules.

2. The thermosetting resin composition according to Claim 1, wherein said epoxy group-containing liquid polybutene (B) has 80 molar % or more of repeating units in the main chain of chemical structure is represented by the following formula (I):

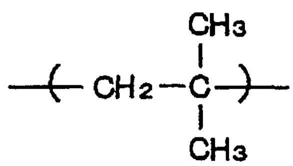

······ ( I )

3. The thermosetting resin composition according to Claim 1 or 2, wherein the epoxy group-containing liquid polybutene (B) has a number average molecular weight in the range of 300 to 6000.

4. The thermosetting resin composition according to any one of Claims 1 to 3, wherein the thermosetting resin composition has a phase of a sea-island structure mainly composed of a continuous phase (1) and dispersed phases (2).

5. The thermosetting resin composition according to any one of Claims 1 to 3, wherein the main phase structure in the resin phase is a sea-island structure composed of a continuous phase (1) and dispersed phases (2), including finer dispersed phases (2-1) which exist within said dispersed phases (2).

6. The thermosetting resin composition according to any one of Claims 1 to 3, wherein the main phase structure in the resin phase is a sea-island structure composed of a continuous phase (1), disperse phases (2) and interfacial phases (3) which surround said dispersed phases (2), respectively.

7. The thermosetting resin composition according to any one of Claims 1 to 3, wherein said thermosetting resin (A) is any one of epoxy resin and phenol resin.

8. In a method for preparing a thermosetting resin composition which is produced by curing a composition composed of a thermosetting resin (A), epoxy group-containing liquid polybutene (B) having epoxy structures formed substantially only at terminal ends of molecules, a curing agent (C) and a curing accelerator (D), wherein said preparation method is **characterized in that** it contains a step to produce a liquid suspension consisting of said epoxy group-containing liquid polybutene (B) and at least one member selected from the group consisting of said thermosetting resin (A), curing agent (C) and curing accelerator (D).

FIG. 1

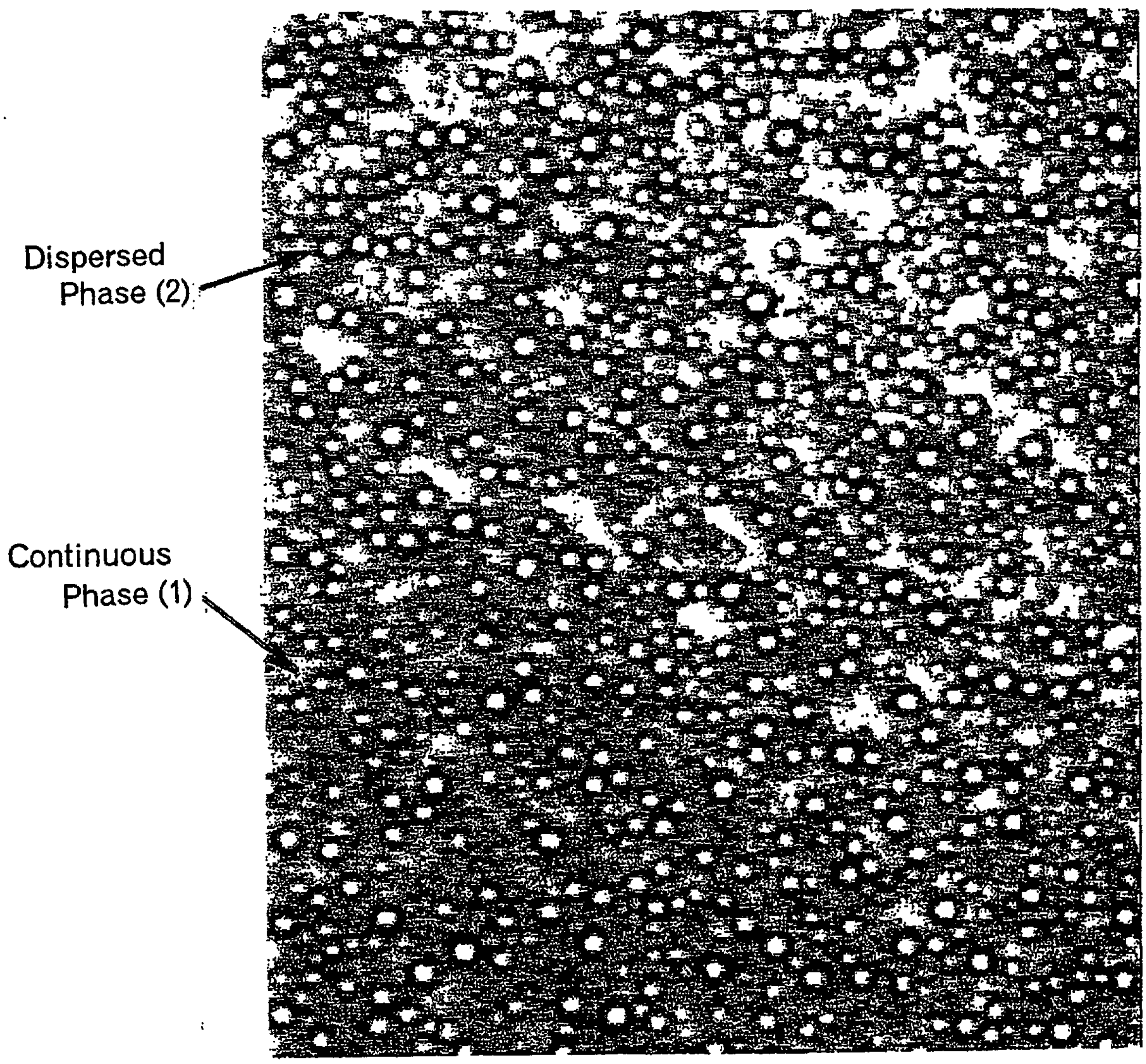

FIG. 2

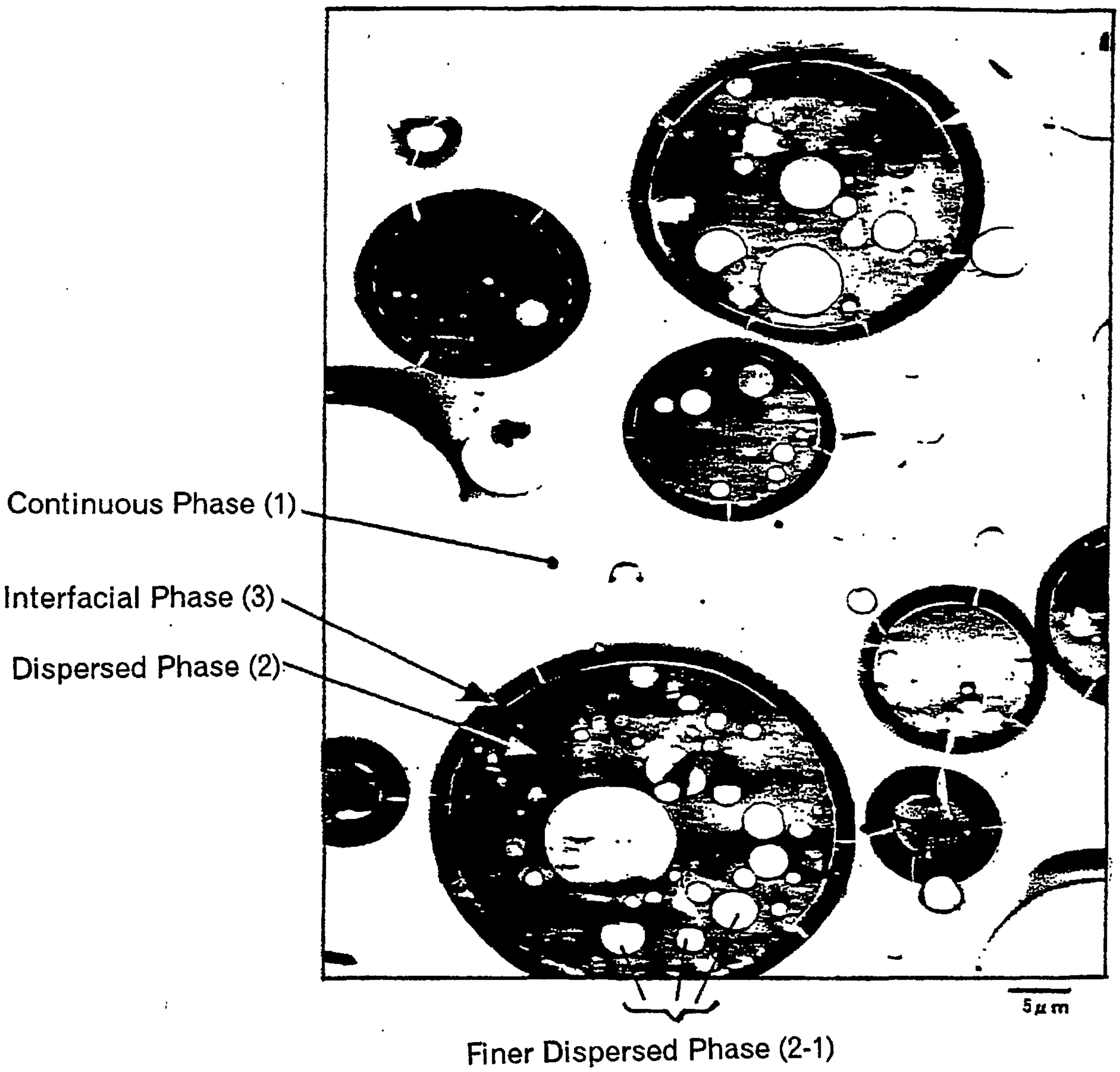
Continuous Phase (1)
Interfacial Phase (3)
Dispersed Phase (2)
5μm
Finer Dispersed Phase (2-1)

FIG. 3

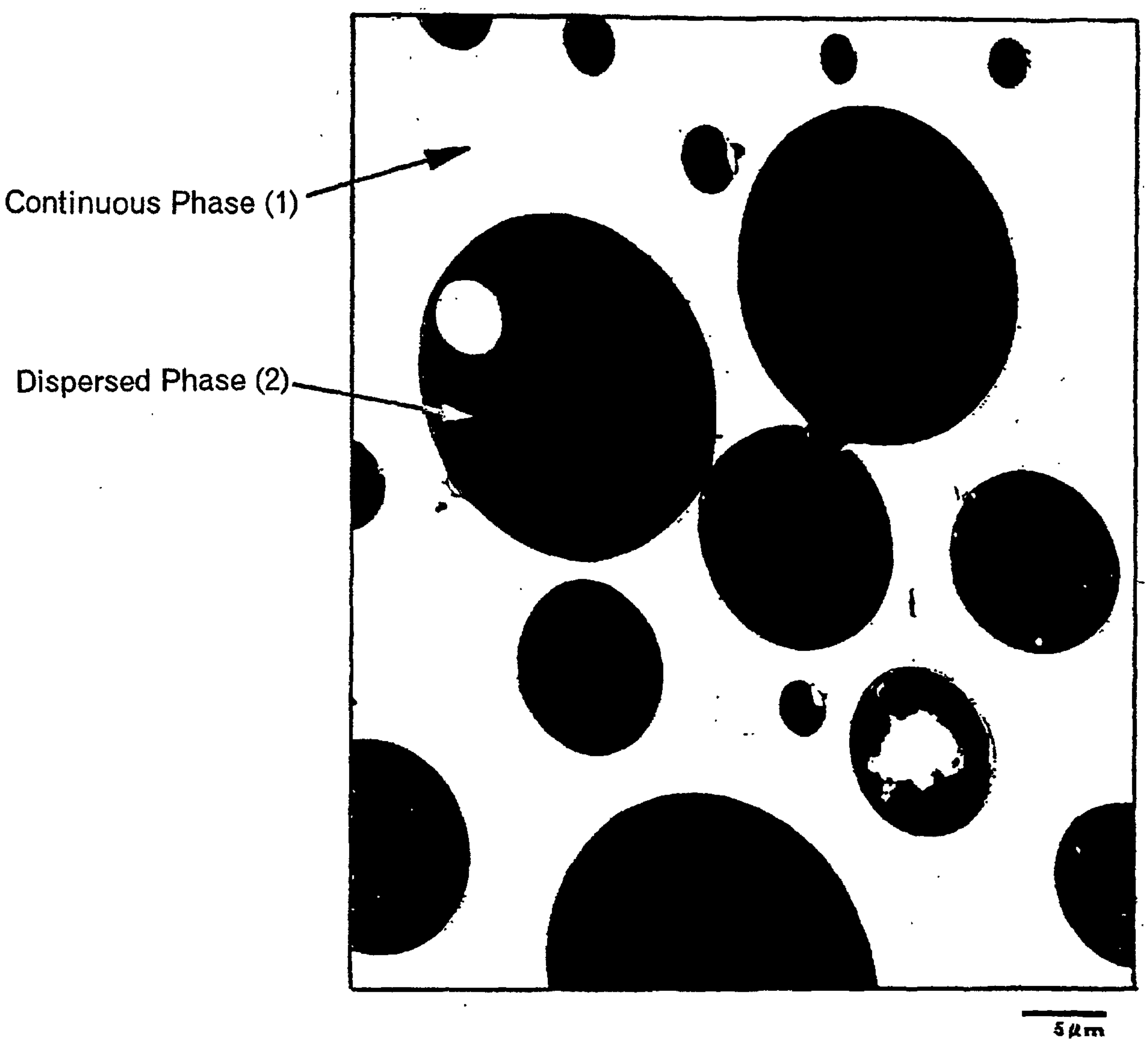

## INTERNATIONAL SEARCH REPORT

International application No.
PCT/JP02/05115

A. CLASSIFICATION OF SUBJECT MATTER
Int.Cl$^7$ C08L101/00, C08L23/30, C08L63/00

According to International Patent Classification (IPC) or to both national classification and IPC

B. FIELDS SEARCHED

Minimum documentation searched (classification system followed by classification symbols)
Int.Cl$^7$ C08L101/00-12, C08L23/30, C08L63/00-10

Documentation searched other than minimum documentation to the extent that such documents are included in the fields searched

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| A | EP 415749 A2 (Amoco Corp.), 06 March, 1991 (06.03.91), Claims & US 5084531 A Claims & US 5225486 A | 1-8 |
| A | JP 2001-89638 A (Toshiba Chemical Corp.), 03 April, 2001 (03.04.01), Claims (Family: none) | 1-8 |
| A | JP 6-306144 A (Nippon Oil Co., Ltd.), 01 November, 1994 (01.11.94), Claims (Family: none) | 1-8 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 August, 2002 (12.08.02) | 03 September, 2002 (03.09.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

International application No.
PCT/JP02/05115

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-41363 A (Nippon Petrochemicals Co., Ltd.), 15 February, 1994 (15.02.94), Claims (Family: none) | 1-8 |
| A | JP 7-220536 A (Hitachi Cable, Ltd.), 18 August, 1995 (18.08.95), Claims (Family: none) | 1-8 |
| A | JP 6-116363 A (Nippon Petrochemicals Co., Ltd.), 26 April, 1994 (26.04.94), Claims (Family: none) | 1-8 |
| A | JP 6-116362 A (Nippon Petrochemicals Co., Ltd.), 26 April, 1994 (26.04.94), Claims (Family: none) | 1-8 |

Form PCT/ISA/210 (continuation of second sheet) (July 1998)